# EUROPEAN PATENT APPLICATION

(11) **EP 4 071 833 A1**
(43) Date of publication of application: **12.10.2022**
(21) Application number: 21167478.3
(22) Date of filing: 08.04.2021
(51) Int. Cl.: H01L 31/05

(54) **SOLAR CELL MODULE WITH HALF CELLS AND METHOD FOR FABRICATING SUCH A SOLAR CELL MODULE**

(71) Applicant: Meyer Burger (Switzerland) AG, 3645 Gwatt/Thun (CH)
(72) Inventor: Zuniga, Erika, 3645 Gwatt (Thun) (CH); Grischke, Rainer, 3645 Gwatt (Thun) (CH); Hänni, Simon, 3645 Gwatt (Thun) (CH); Harnisch, Urs, 3645 Gwatt (Thun) (CH)
(74) Representative: Kailuweit & Uhlemann Patentanwälte Partnerschaft mbB

(57) **Abstract**

The invention refers to a solar cell module comprising half cells arranged in strings. Each half cell has a quasi-rectangular shape and has one long, fully straight edge having no bevels, one long, slanted edge having two bevels, and two short edges each having one bevel. According to the invention, adjacent half cells arranged in one string adjoin or overlap each other either with their long, slanted edges or with their long, fully straight edges. The invention further refers to a method for fabricating such a solar cell module.

## Description

The present invention refers to a solar cell module with half cells and a method for fabricating such a solar cell module.

Solar cell modules comprise a plurality of solar cells arranged in a predefined order, for instance in rows and columns, and electrically connected with each other, for instance in series or in parallel. In this respect, the term "solar cell" refers to a single solar cell substrate which may comprise a plurality of sub-cells which are again electrically connected with each other in series or in parallel. For the electrical connection of individual solar cells each having a front side contact and a back side contact two principal possibilities exist: First, the individual solar cells lie in one plane, wherein an electrical connector connecting for instance a back side contact of a first solar cell with a front side contact of a second solar cell adjacent to the first solar cell in the case of a series connection of the two solar cells is bound to span the height difference between the back side contact of the first solar cell and the front side contact of the second solar cell. Second, the individual solar cells lie in different planes, wherein a first solar cell overlaps a second solar cell adjacent to the first solar cell and electrically connected to the first solar cell in series In this case, the electrical connector may be a straight, unbound connector.

A recent development in solar cell technology is the use of half cells instead of full cells. In this case, a "normal" full cell, for instance a quadratic cell with a size of (16.6 x 16.6) cm², is cut in two half cells, each being a rectangular cell with a size of approximately (16.6 x 8.3) cm². A solar module comprising such half cells has different advantages, in particular higher efficiency due to lower resistance losses, better usage of the incoming light, less temperature effects and less shading effects.

In the case of monocrystalline solar cells, the substrates for the solar cells are formed by cutting slices out of a circular semiconductor ingot, in particular a silicon ingot. In order to get the largest substrate out of the ingot, the substrates are quadratic with bevels at the corners. The bevels may have, for instance, an angle of 135° to the adjacent edges of the substrate.

If such a full cell substrate is cut into two half cells after forming the solar cell on it, i.e. if a full solar cell is cut into two half cells, each half cell has two corners having a bevel and two corners having no bevel. That is, each half cell has one long, fully straight edge having no bevels, one long, slanted edge having two bevels and two short edges each having one bevel. The half cells are then further processed, in particular arranged with other half cells into a solar cell module and electrically connected to at least one other half cell. Due to the fabrication processes, e.g. alignment of the solar cells for arranging and connecting, all half cells connected in one string, for instance in a column, are arranged in the same direction within the solar module. For this purpose, one of the two half cells of each pair of half cells resulting from cutting one full solar cell is turned by 180° in the plane of its planar extension. This plane extends perpendicular to the thickness direction of the full cell or the half cell, wherein the thickness direction extends from the front side of the solar cell to the back side of the solar cell. In the result, all half cells within a string are arranged such that a long, fully straight edge of a first solar cell is adjacent to a long, slanted edge of a second solar cell.

However, in the case of overlapping solar cells as described above, the straight corners of the long, fully straight edge of the first half cell overlap the bevels of the long, slanted edge of the second half cell. The overlapping cell corners are subject to higher leverage forces as they are exposed to a height difference of solar cell thickness and thickness of the electrical connector. Even in the case of individual solar cells lying in one plane and of electrical connectors being bound as described above, it is disadvantageous if different cell corners, i.e. cell corners with a bevel and cell corners without a bevel, adjoin or meet each other. In both cases, the potential for pinching and/or cracking of the solar cells and/or of the electrical connectors and thus for reducing the efficiency of the solar module is increased.

The object of the present invention is to provide a solar cell module comprising half cells which overcomes the disadvantages of the prior art. A further object of the present invention is to provide a method for fabrication such a solar cell module.

This object is solved by a solar cell module and a method according to the independent claims. Preferred embodiments are given in the dependent claims.

According to the present invention, the solar cell module comprises half cells arranged in strings. A string is a plurality of half cells electrically connected in series and arranged along a straight line. Each half cell has a quasi-rectangular shape and has one long, fully straight edge having no bevels, one long, slanted edge having two bevels, and two short edges each having one bevel. According to the invention, adjacent half cells arranged in one string adjoin or overlap each other either with their long, slanted edges or with their long, fully straight edges. That is, in each joining region or at each overlap of a string, similar edges of the adjacent solar half cells overlap. Thus, the mechanical stress at the adjoining or overlapping corners of the half cells and/or the respective electrical connectors is reduced. In the result, the risk of pinching and/or cracking of the solar half cells and/or of the electrical connectors, e.g. of inducing microcracks, is eliminated or at least highly reduced resulting in higher reliability of the solar module.

In embodiments of the invention, a joining region or an overlap region in which adjacent half cells adjoin or overlap each other, respectively, has a width measured along the string direction in the range of 0 mm to 1.5 mm, for instance 0.5 mm to 1.5 mm. The width of the overlap region may be, for instance, 1 mm.

In embodiments of the invention, electrical connectors electrically connecting adjacent half cells in series are fixed to each of the connected half cells by an adhesive foil. That is, the electrical connectors are arranged between the surface of the half cell and the adhesive foil and the adhesive foil is fixed to the surface of the half cell in regions where no electrical connector is arranged. In special embodiments, the electrical connectors are formed as wires. This kind of electrical connection of solar cells is known as Smart-Wire-Connection-Technology. The number of electrical connectors connecting two adjacent half cells may be, for instance in the range of 4 to 30.

Ideally, adjacent half cells are not shifted with respect to each other along a lateral direction perpendicular to the string direction. A lateral direction is a direction within the plane of the planar extension of the solar half cell. However, there may be a lateral mismatch between adjacent half cells, i.e. the half cells may be shifted with respect to each other along the lateral direction. This mismatch may be smaller than 1.5 mm, preferably smaller than 0.5 mm.

The method according to the invention for fabricating a solar module comprises the steps of providing at least one full solar cell, cutting each full solar cell into two half cells, and arranging and electrically connecting a plurality of half cells into a string. The fabricated solar module comprises at least one string of half cells.

In the step of providing at least one full solar cell a principally finished and operable solar cell is provided. Each full solar cell has a quasi-quadratic shape and has a bevel at each corner. Then, each of the full solar cells is cut into two half cells which are physically and electrically separated from each other. Each half cell has a quasi-rectangular shape and has one long, fully straight edge having no bevels, one long, slanted edge having two bevels, and two short edges each having one bevel. The half cells are then arranged into a string and electrically connected in series within the string. The half cells are arranged such that two adjacent half cells in the string adjoin or overlap each other either with their long, slanted edges or with their long, fully straight edges. No step of turning one of the half cells by 180° in the plane of its planar extension, as needed in the method according to the prior art, is necessary. Thus, production costs may be saved and a process step, i.e. the step of turning a half cell, causing a risk for damaging the half cell is saved.

In embodiments of the method according to the invention the step of providing at least one full solar cell comprises steps for producing the at least one full solar cell. Such steps for producing may be, for instance, doping, applying of layers like contact layers, isolating layers or antireflection layers, structuring or applying contacts.

In embodiments of the method according to the invention, electrical connectors electrically connecting adjacent half cells in series within the string are fixed to the half cells using an adhesive foil.

The invention is dedicated to the alignment of slanted edges and edges having the full length of the wafer dimension during the interconnection or stringing process. But this shall not exclude that a wafer can be divided in more than two parts, for example in three or four pieces. In this case the individualised parts of the wafer pieces having slanted edges will be connected in series in a way that slanted edges oppose each other.

The accompanying drawings are included to provide a further understanding of embodiments of the invention and are incorporated in and constitute a part of this specification. The drawings illustrate the embodiments of the present invention and together with the description serve to explain the principles. Other embodiments of the invention and many of the intended advantages will be readily appreciated, as they become better understood by reference to the following detailed description. The elements of the drawings are not necessarily to scale relative to each other. Like reference numbers designate corresponding similar parts.
- Fig. 1: schematically shows a part of a solar cell module according to a first embodiment of the present invention in a side view.
- Fig. 2: schematically shows two overlapping half cells of a solar cell module according to the prior art in a plan view.
- Fig. 3A and 3B: schematically show the two possibilities for overlapping of two adjacent half cells of a solar cell module according to the first embodiment of the present invention in a plan view.
- Fig. 4: schematically shows a part of a solar cell module according to a second embodiment of the present invention in a side view.
- Fig. 5A and 5B: schematically show the two possibilities for adjoining of two adjacent half cells of a solar cell module according to the second embodiment of the present invention in a plan view.
- Fig. 6: schematically shows a method for fabricating a solar cell module according to an embodiment of the present invention.
- Fig. 7A and 7B: schematically show two embodiments for arranging half cells in a string in a plan view.
- Fig. 8: schematically shows connectors fixed to a surface of a half cell by an adhesive foil in a side view.

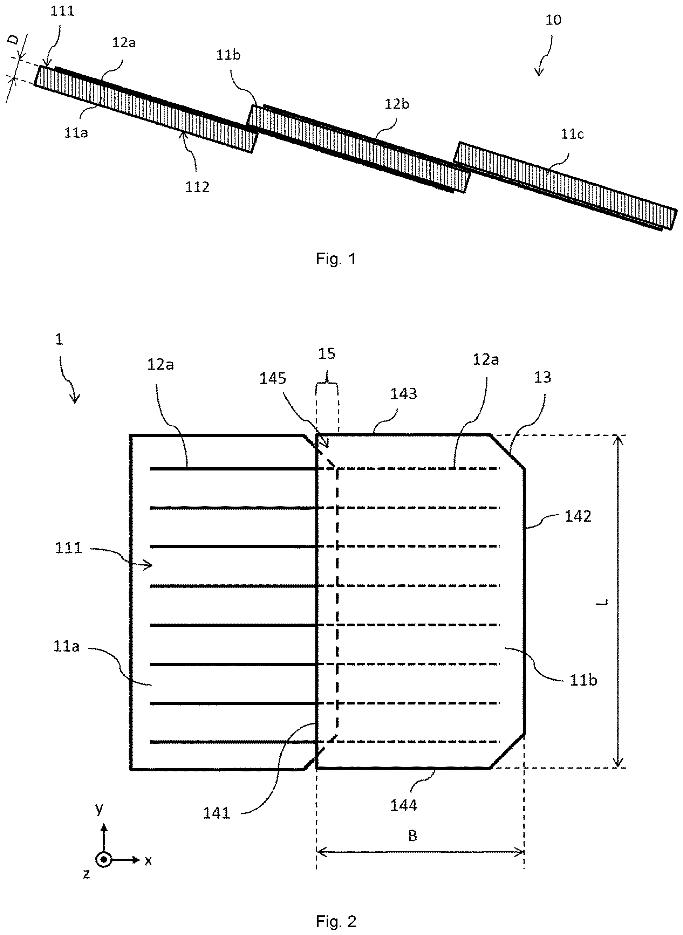

Figure 1 schematically shows a part of a solar cell module 10 according to a first embodiment of the present invention in a side view. In particular, Figure 1 shows three solar half cells 11a to 11c of one string, wherein the half cells 11a to 11c are connected in series and adjacent half cells 11a and 11b or 11b and 11c, respectively, overlap each other. Each half cell 11a to 11c has a front side 111 and a back side 112 and a thickness D measured from the front side 111 to the back side 112. Adjacent half cells 11a to 11c are electrically connected to each other by electrical connectors 12a, 12b, which are, for instance, straight metallic stripes or wires connected to the back side of one of the two adjacent half cells 11a to 11c and to the front side of the other one of the two adjacent half cells 11a to 11c.

Figure 2 schematically shows two overlapping half cells of a solar cell module according to the prior art in a plan view on the front sides 111 of the half cells. For example, adjacent half cells 11a and 11b are shown which are electrically connected by the connector 12a. Since the connector 12a is connected to the back side of the half cell 11b as explained with respect to Fig. 1, it is shown only by dashed lines in the region of the half cell 11b. Each half cell 11a and 11b has a width B measured along a first direction being the direction of the string. The first direction is referenced by x in Figure 2. Each half cell 11a and 11b has a length L measured along a second direction perpendicular to the first direction and referenced by y in Figure 2. The thickness of a half cell as explained with reference to Fig. 1 is measured in a third direction perpendicular to the x-y-plane and referenced by z in Figure 2. The width B of a half cell is approximately half of the length L of the same half cell. Each half cell 11a, 11b has two bevels 13 and four edges which are referenced and explained with respect to half cell 11b by way of example: a long, fully straight edge 141 having no bevel, a long, slanted edge 142 having two bevels 13 and two short edges 143 and 144 each having one bevel 13. That is, one bevel 13 connects the long, slanted edge 142 with the short edge 143 and the other bevel 13 connects the long, slanted edge 142 with the short edge 144. The half cells 11a and 11b overlap in an overlap region 15, wherein the corners of the long, fully straight edge 141 of the half cell 11b are overlapping corners 145 overlapping the bevels 13 of the half cell 11a.

Although Fig. 2 shows the arrangement of half cells according to the prior art for the case that the half cells overlap each other, the half cells may also adjoin each other in the prior art while being arranged in the same way.

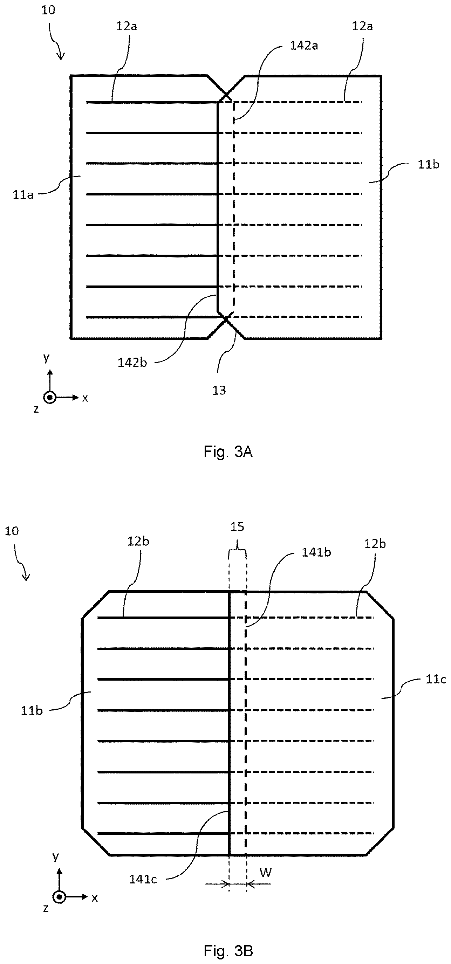

Figures 3A and 3B schematically show the two possibilities for overlapping of two adjacent half cells of a solar cell module according to the first embodiment of the present invention in a plan view on the front sides of the half cells.

Figure 3A shows the half cells 11a and 11b electrically connected by the connector 12a. Here, the two long, slanted edges 142a and 142b of the half cells 11a and 11b overlap each other. Contrary to prior art, no overlapping corners 145 as explained with respect to Fig. 2 are present. Only bevels 13 overlap for a small amount.

Figure 3B shows the half cells 11b and 11c electrically connected by the connector 12b. Here, the two long, fully straight edges 141b and 141c of the half cells 11b and 11c overlap each other. Again, no overlapping corners 145 as explained with respect to Fig. 2 are present.

The overlap region 15 referenced for example in Fig. 3A has a width W measured along the first direction.

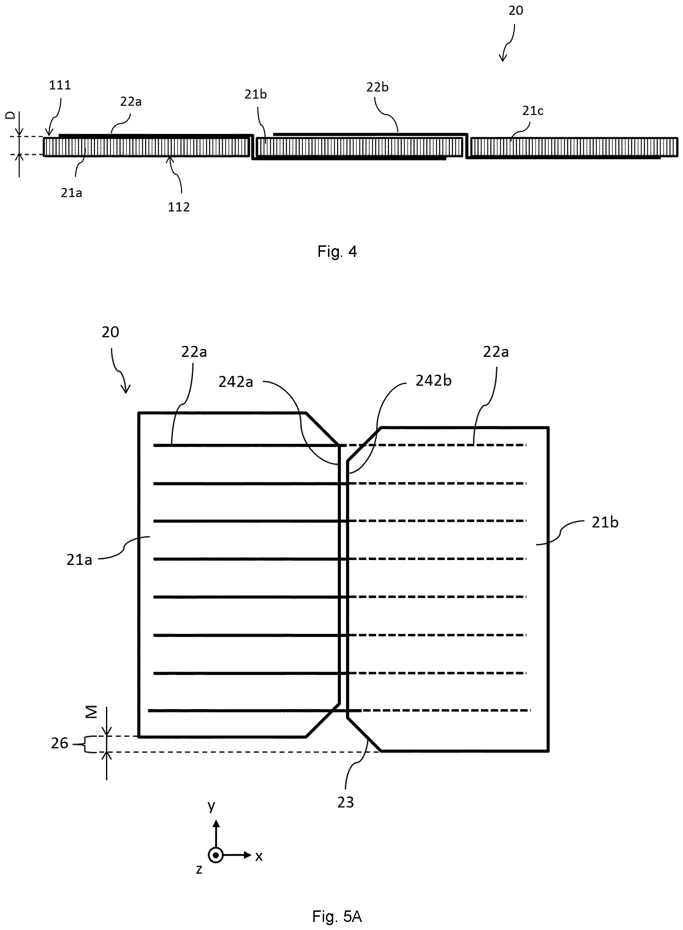

Figure 4 schematically shows a part of a solar cell module 20 according to a second embodiment of the present invention in a side view. In particular, Figure 4 shows three solar half cells 21a to 21c of one string, wherein the half cells 21a to 21c are connected in series and lie in the same plane. That is, adjacent half cells 21a and 21b or 21b and 21c, respectively, adjoin each other. Each half cell 21a to 21c has a front side 211 and a back side 212 and a thickness D measured from the front side 211 to the back side 212. Adjacent half cells 21a to 21c are electrically connected to each other by electrical connectors 22a, 22b, which are, for instance, bounded metallic stripes or wires connected to the back side 212 of one of the two adjacent half cells 21a to 21c and to the front side 211 of the other one of the two adjacent half cells 21a to 21c.

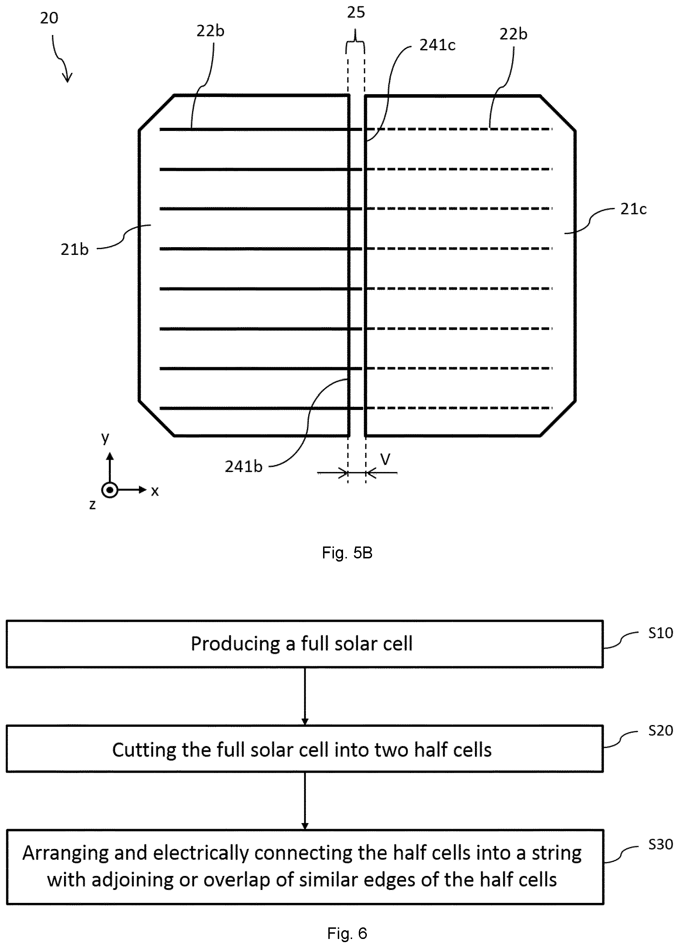

Fig. 5A and 5B schematically show the two possibilities for adjoining of two adjacent half cells of a solar cell module according to the second embodiment of the present invention in a plan view on the front sides of the half cells.

Figure 5A shows the half cells 21a and 21b electrically connected by the connector 22a. Here, the two long, slanted edges 242a and 242b of the half cells 21a and 21b, each long, slanted edge 242a, 242b having two bevels 23, adjoin each other.

Figure 5B shows the half cells 21b and 21c electrically connected by the connector 22b. Here, the two long, fully straight edges 241b and 241c of the half cells 21b and 21c adjoin each other.

A joining region 25, in which the adjacent half cells 21b and 21c adjoin each other, referenced for example in Fig. 5B has a width V measured along the first direction. That is, the adjacent half cells 21b and 21c are arranged to each other with a distance equal to the width V. This distance is used for the change of the connector 22b from the front side of the half cell 21b to the back side of the half cell 21c.

Furthermore, a mismatch 26 having a length M measured along the second direction is shown in Fig. 5A. That is, the half cells 21a and 21b are shifted with respect to each other along the second direction by the length M. The half cells 21b and 21c shown in Fig. 5B are not shifted with respect to each other along the second direction, i.e. there is no mismatch.

Although the first embodiment and the second embodiment are shown with straight connectors or with bounded connectors, respectively, each embodiment may also be formed in the opposed way. That is, overlapping half cells as described with respect to the first embodiment may also be connected by bounded connectors, and adjoining half cells as described with respect to the second embodiment may also be connected by straight connectors.

Fig. 6 schematically shows a method for fabricating a solar cell module according to an embodiment of the present invention. First, at least one full solar cell is produced according to the prior art in step S10. Usually, a plurality of full solar cells is produced, for instance60 for one solar module. Each full solar cell has a quasi-quadratic shape and has a bevel at each corner.

Next, each full solar cell is cut into two physically and electrically separated half cells in step S20. This step is also known from prior art and may be performed, for instance, by laser cutting. In the result, each half cell has a quasi-rectangular shape and has one long, fully straight edge having no bevels, one long, slanted edge having two bevels, and two short edges each having one bevel.

In step S30, a plurality of half cells, i.e. at least two half cells, are arranged into a string and electrically connected in series within the string. According to the invention, the half cells are arranged such that similar edges of the half cells adjoin or overlap each other. That is, two adjacent half cells in the string adjoin or overlap each other either with their long, slanted edges or with their long, fully straight edges.

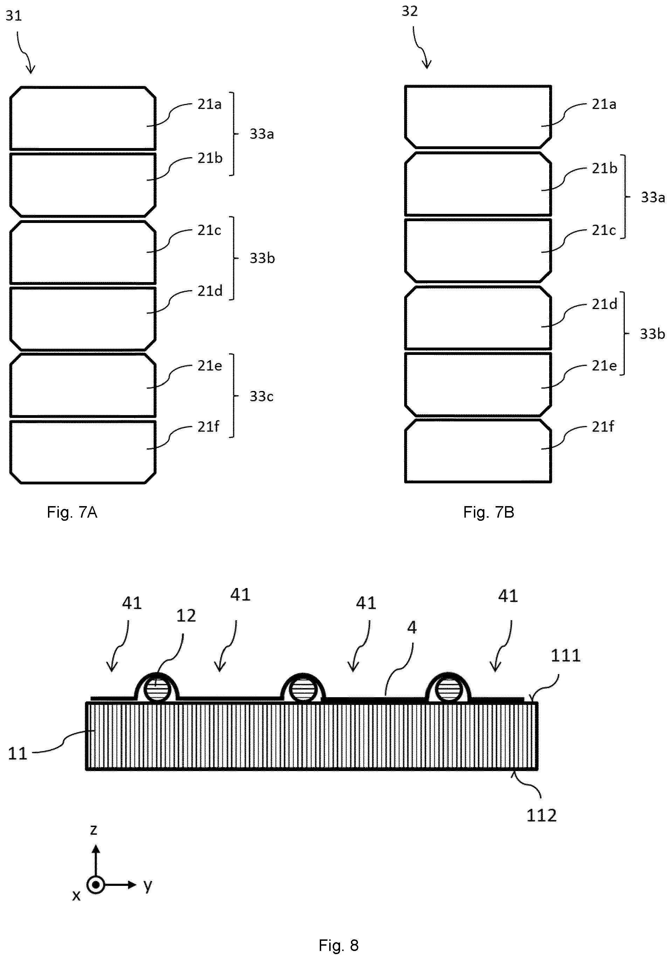

Figures 7A and 7B schematically show two embodiments for arranging half cells in a string 31 or 32 in a plan view. In each case, six half cells 21a to 21f are connected with each other within a string. For better visualisation of the different arrangements, electrical connectors are omitted and the case of adjoining half cells is shown. However, the same arrangements may be formed with overlapping half cells.

In the embodiment shown in Fig. 7A, every two half cells are arranged such that they form a pseudo full cell 33a to 33c. That is, the appearance of the whole string 31 is very similar to that of a solar module with full solar cells.

In the embodiment shown in Fig. 7B, the half cells are arranged such that the string 32 begins with a separated half cell 21a. Then half cells 21b and 21c as well as half cells 21d and 21e form two pseudo full cells 33a and 33b. At the end of the string 32, again a separated half cell 21f is arranged.

Although an even number of half cells within a string is arranged in the shown embodiments, an odd number of half cells may be arranged within a string, too. Furthermore, the number of half cells is not limited to the shown number.

Figure 8 schematically shows connectors 12 fixed to a surface, for instance the front side 111, of a half cell 11 by an adhesive foil 4 in a side view on the half cell 11. The connectors 12 are arranged between the front side 111 and the adhesive foil 4. The adhesive foil 4 is fixed to the front side 111 of the half cell 11 in regions 41 where no connectors 12 are arranged. Although the arrangement of connectors on the front side 111 of the half cell 11 is shown, connectors may be fixed to the back side 112 of the half cell 11 in the same way, i.e. also by an adhesive foil.

Although the description above refers to half cells, the inventive idea may also be applied to other partial cells resulting from other divisions of a full cell. If, for instance, a full cell is divided into three partial cells, two of the partial cells have a shape similar to the half cells described above. That is, these partial cells have a long, slanted edge with two bevels, a long, fully straight edge with no bevel and two short edges each having one bevel. The third partial cell then only has fully straight edges with no bevels at all. Each of these partial cells may be arranged with respect to an adjacent partial cell in a string in the same way as described with respect to the half cells above. That is, each two adjacent partial cells within a string adjoin or overlap with each other either with their long, slanted edges or with their long, fully straight edges. If, for instance, a full cell is divided into four partial cells, all of these partial cells may have a quasi-quadratic shape with only one bevel. That is, each of these partial cells has two slanted edges adjacent to one bevel and two fully straight edges. In this case, adjacent partial cells within a string may be arranged such that they adjoin or overlap with each other with similar edges, i.e. either with their slanted edges or with their fully straight edges. In case the partial cells adjoin or overlap with their slanted edges, the bevels of the partial cells are arranged at the same lateral side of the partial cells, that is the bevels lie opposite to each other. A person skilled in the art may adapt the inventive idea described above to an arbitrary number of partial cells resulting from dividing a full cell. Thus, a solar module and a method for fabricating a solar module may be adapted for partial cells instead of half cells.

The embodiments of the invention described in the foregoing description are examples given by way of illustration and the invention is nowise limited thereto. Any modification, variation and equivalent arrangement as well as combinations of embodiments should be considered as being included within the scope of the invention.

### Reference numerals

- 1: Solar module according to prior art
- 10, 20: Solar module according to invention
- 11, 11a- 11c,: Half cell
- 21a-21f 111, 211: Front side of a half cell
- 112, 212: Back side of a half cell
- 12, 12a, 12b,: connector
- 22a, 22b 13, 23: bevel
- 141, 141b, 141c: Long, fully straight edge of a half cell
- 241b, 241c 142, 142a, 142b: Long, slanted edge of a half cell
- 242a, 242b 143, 144: Short edge of a half cell
- 145: Overlapping corner of a half cell
- 15: Overlap region
- 25: Joining region
- 26: Mismatch
- 31, 32: String
- 33a - 33c: Pseudo full cell
- 4: Adhesive foil
- 41: Region of a half cell

- B: Width of a half cell
- D: Thickness of a half cell
- L: Length of a half cell
- M: Length of the mismatch
- V: Width of the joining region
- W: Width of the overlapping region

## Claims

1. A solar cell module (10, 20) comprising half cells (11a- 11c, 21a-21c) arranged in strings, wherein each half cell (11a - 11c, 21a -21c) has a quasi-rectangular shape and has one long, fully straight edge (141) having no bevels, one long, slanted edge (142) having two bevels (13), and two short edges (143, 144) each having one bevel (13),
**characterized in that**
adjacent half cells (11a - 11c, 21a - 21c) arranged in one string adjoin or overlap each other either with their long, slanted edges (142a, 142b, 242a, 242b) or with their long, fully straight edges (141b, 141c, 241b, 241c).

2. The solar cell module according to claim 1, **characterized in that** a joining region (25) or an overlap region (15) in which adjacent half cells (11a- 11c, 21a-21c) adjoin or overlap has a width (V, W) along the string direction in the range of 0.5 mm to 1.5 mm.

3. The solar cell module according to claim 1 or 2, **characterized in that** electrical connectors (12) electrically connecting adjacent half cells (11) with each other within a string are fixed to the half cells (11) by an adhesive foil (4).

4. A method for fabricating a solar cell module (10, 20) comprising half cells (11a - 11c, 21a - 21c) arranged in strings, the method comprising the steps of:
- providing at least one full solar cell, wherein each full solar cell has a quasi-quadratic shape and has a bevel (13) at each corner,
- cutting each full solar cell into two physically and electrically separated half cells (11a - 11c, 21a - 21c), wherein each half cell (11a - 11c, 21a - 21c) has a quasi-rectangular shape and has one long, fully straight edge (141) having no bevels, one long, slanted edge (142) having two bevels (13), and two short edges (143, 144) each having one bevel (13), and
- arranging a plurality of half cells (11a - 11c, 21a - 21c) into a string and electrically connecting the half cells in series within the string,
**characterized in that**
the half cells are arranged within the string such that two adjacent half cells (11a - 11c, 21a - 21c) in the string adjoin or overlap each other either with their long, slanted edges (142a, 142b, 242a, 242b) or with their long, fully straight edges (141b, 141c, 241b, 241c).

5. The method according to claim 4, **characterized in that** the step of providing at least one full solar cell comprises steps for producing the at least one full solar cell.

6. Method of claim 4 or 5, **characterized in that** electrical connectors (12) electrically connecting the half cells (11) in series within the string are fixed to the half cells (11) using an adhesive foil (4).
